# Europäisches Patentamt

# European Patent Office

# Office européen des brevets

(11) Veröffentlichungsnummer : **0 525 703 B1**

(12) # EUROPÄISCHE PATENTSCHRIFT

(45) Veröffentlichungstag der Patentschrift :
**29.11.95 Patentblatt 95/48**

(51) Int. Cl.⁶ : **H01R 13/719, H04B 3/32**

(21) Anmeldenummer : **92112808.8**

(22) Anmeldetag : **27.07.92**

(54) **Steckverbindung für Computernetze im Hausbereich.**

(30) Priorität : **01.08.91 DE 4125546**

(43) Veröffentlichungstag der Anmeldung :
**03.02.93 Patentblatt 93/05**

(45) Bekanntmachung des Hinweises auf die
Patenterteilung :
**29.11.95 Patentblatt 95/48**

(84) Benannte Vertragsstaaten :
**AT BE CH DE DK ES FR GB IT LI NL SE**

(56) Entgegenhaltungen :
**EP-A- 0 421 174**
**DE-A- 3 145 039**
**JP-A-63 211 692**
**US-A- 4 726 790**

(73) Patentinhaber : **SIEMENS**
**AKTIENGESELLSCHAFT**
**Wittelsbacherplatz 2**
**D-80333 München (DE)**

(72) Erfinder : **Ortkrass, Gerd**
**Sonnleitenweg 10**
**W-8195 Egling 1 (DE)**
Erfinder : **Odemar, Norbert**
**Hofbrunnstrasse 9**
**W-8000 München 71 (DE)**

EP 0 525 703 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

**Beschreibung**

Die Erfindung betrifft eine Steckverbindung für Computernetze im Hausbereich, bestehend aus einem Stecker- und einem Buchsenteil.

Bei lokalen Netzen für Computersysteme ist das modulare Stecksystem RJ 45 (8-polig) oder RJ 11 (6-polig) Bestandteil der Verkabelung (zwei verdrallte Leiterpaare, twisted pairs) an den Verteilerpunkten und den Geräteanschlußdosen. Die Kontaktbelegung ist inzwischen vorgegeben und hängt vom entsprechenden System ab (zum Beispiel 10-Base-T, Token Ring) und ist standardisiert in der Belegung der Anschlußeinheiten.

Die Systemreichweiten solcher Netze hängen vom Verhältnis Stör- zu Nutzsignal ab, das heißt bei Fehlen fremder Störer von der Differenz der Nahnebensprechdämpfung zur Dämpfung der Verkabelung. Nun ist die Nahnebensprechdämpfung des Kabels oft besser als die des Stecksystems mit der bereits festgelegten Kontaktbelegung. Die engen Begrenzungen der Reichweiten wurden jedoch bisher in Kauf genommen. Vergrößerungen der Reichweiten sind mit den bisherigen Stecksystemen jedoch Grenzen gesetzt.

Der Erfindung liegt nun die Aufgabe zugrunde, die Nahnebensprechdämpfung der Verkabelung hinsichtlich des gegebenen Stecksystems mit bereits festgelegter Kontaktbelegung an den Anschlußelementen mit geeigneten Verfahren und entsprechenden Schaltungsmaßnahmen zu verbessern. Die gestellte Aufgabe wird mit einer Steckverbindung der eingangs erläuterten Art dadurch gelöst, daß eine Einrichtung zur Nebensprechkompensation in der Steckverbindung angeordnet ist, mit der die Nebensprechdämpfung zwischen der Sende- und der Empfangsleiterschleife erhöhbar ist.

Weiterhin wird die Aufgabe durch entsprechende Verfahrensweisen nach den Merkmalen der Ansprüche 9 bis 12 gelöst.

Im Tertiärbereich von Verkabelungssystemen mit Computern, insbesondere in der Etagenverkabelung sind folgende Bestandteile vorgegeben: Erdsymmetrische verdrillte Paare (twisted pairs), RJ 45-Buchsen (Modular Jack) in den Verteilerschränken und Geräteanschlußdosen sowie mit RJ 45-Steckern konfektionierte Geräteanschluß- und Rangierkabel. Dabei sind die Kontaktbelegungen bei den Buchsen RJ 45 für die verschiedenen Systeme standardisiert und festgelegt, wie zum Beispiel die Anschlüsse 4 und 5 für die Empfängerschleife und die Anschlüsse 3 und 6 für die Senderschleife. Bei dem 10-BASE-T-System sind für die Empfängeranschlüsse die Steckbelegungen 1 und 2 und für die Senderschleife die Anschlüsse 3 und 6 vorgesehen. Nun ist jedoch gerade die Token-Ring-Belegung hinsichtlich der Nahnebensprechdämpfung im Vergleich zum Kabel schlecht. Die Dämpfung und das Nahnebensprechen beeinflussen jedoch die Systemreichweite. Es ist deshalb vorteilhaft, eine Nebensprechkompensation gemäß der Erfindung einzuführen, die eine Erhöhung der Nahnebensprechdämpfung ergibt, so daß dadurch die Reichweite erhöht werden kann. Die bei den genannten Systemen verwendeten Steckverbindungen bestehen im wesentlichen aus einer Aufnahmebuchse für den jeweiligen Stecker eines Geräteanschluß- oder Rangierkabels und einer Leiterplatine, die zur Weiterleitung und Rangierung auf die Anschlußkontakte der Verkabelung dient. Nun erfolgt bei den bisherigen Steckverbindungen auf der Leiterplatine zwischen den ankommenden Anschlüssen und den abgehenden Anschlüssen eine Überkopplung zwischen den einzelnen Leitern. So wird von der störenden auf die gestörte Leitung eine bestimmte Leistung übergekoppelt, wobei die Maßzahl hierfür die Nebensprechdämpfung ist. Je geringer diese Nebensprechdämpfung ist, umso größer wird die eingekoppelte Störung. Bei der Erfindung wird nun durch eine gezielte Nebensprechkompensation diese Störleistung verringert bzw. kompensiert, wobei eine gezielte Überkopplung einer zusätzlichen gleichgroßen, jedoch gegenphasigen Leistung angestrebt wird. Eine derartige Nebensprechkompensation gemäß der Erfindung kann sowohl durch entsprechende Führungen der Leiter, zum Beispiel durch "Auskreuzung", wie auch durch Zuschaltung diskreter Bauteile, wie Kondensatoren oder Spulen erreicht werden. So wird beispielsweise das "Auskreuzen" vorgezogen, wenn der vorhandene Platz ausreicht, da dadurch elektrische (kapazitive) wie magnetische (induktive) Kopplungen gleichermaßen kompensiert werden können. Bei den getroffenen Maßnahmen gemäß der Erfindung ist jedoch Voraussetzung, daß eine solche Kompensation nicht zu Anschlußveränderungen führen darf, da die getroffenen Maßnahmen auch in bestehenden Systemen eingesetzt werden müssen. Damit diese Kontaktzuordnungen erhalten bleiben, wird eine "Rückkreuzung" vorgesehen, so daß der bei der ersten "Auskreuzung" erfolgte Lagetausch wieder rückgängig gemacht wird.

Die Erfindung wird nun anhand von dreizehn Figuren näher erläutert.

| | |
|---|---|
| Figur 1 | zeigt die Störverhältnisse bei nicht kompensierter Leitungsführung. |
| Figur 2 | zeigt den Leiterverlauf und die Anschlußkontakte auf der Leiterplatine einer herkömmlichen Steckverbindung. |
| Figur 3 | zeigt eine Nebensprechkompensation gemäß der Erfindung durch doppelte "Auskreuzung". |
| Figur 4 | zeigt die Anordnung zur Messung des Nebensprechens bei herkömmlichen Verbindungssystemen. |
| Figur 5 | zeigt eine Meßanordnung mit einem gegenüber Figur 4 zusätzlichen kurzen Kabelstück, wobei |

die übliche Kontaktbelegung verwendet ist.

Figur 6        zeigt eine Meßanordnung, bei der in der Steckverbindung die Anschlüsse der Empfängerschleife vertauscht sind.

Figur 7        zeigt Meßergebnisse, die nach Anordnungen der Figuren 4 und 5 ermittelt wurden.

Figur 8        zeigt Meßergebnisse, die nach Figur 4 und 6 ermittelt wurden.

Figur 9        zeigt ein Beispiel für die Nebensprechkompensation gemäß der Erfindung durch "Auskreuzen".

Figur 10       zeigt die Kopplungsverhältnisse an den Leitern auf der Steckverbindung.

Figur 11       zeigt ein Ersatzschaltbild für die entsprechenden Koppelverhältnisse.

Figur 12       zeigt eine Nebensprechkompensation gemäß der Erfindung mit Hilfe von Kondensatoren.

Figur 13       zeigt eine Nebensprechkompensation gemäß der Erfindung mit Hilfe von Spulen bzw. Transformatoren.

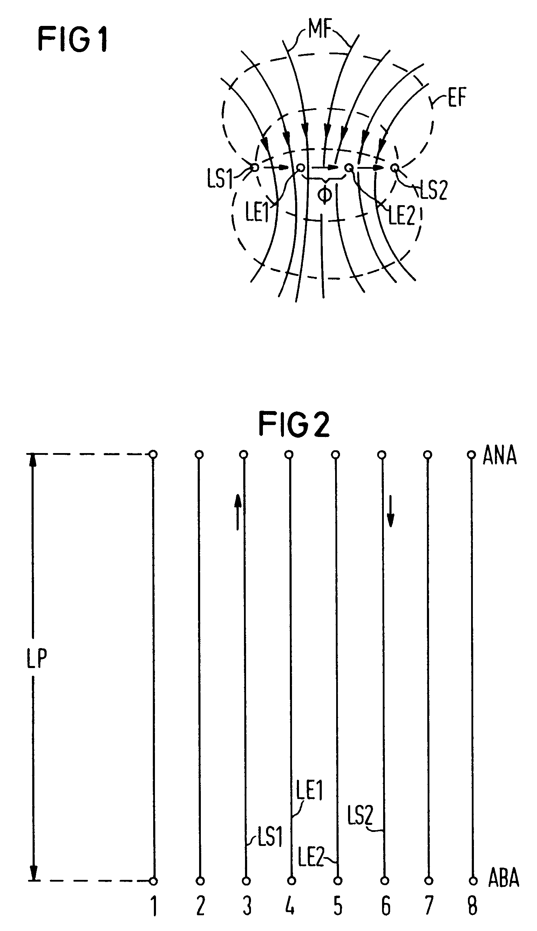

In Figur 1 ist die prinzipielle Anordnung in der Steckverbindung, zum Beispiel RJ 45-Verbindung mit der beim "Token Ring-System" verwendeten Belegung 4 und 5 für die Empfängerschleife LE1 und LE2 und der Belegung 3-6 für die Senderschleife LS1 und LS2 aufgezeigt. Dabei verlaufen die Leiterbahnen parallel zueinander. Aus der Darstellung geht die systematische Verkopplung der beiden Schleifen LS1-LS2 und LE1-LE2 hervor, wobei die beim Durchfluß entstehenden elektrischen (EF) und magnetischen (MF) Feldlinien angedeutet sind. Ein Teil des Potentialunterschiedes (des elektrischen Feldes) zwischen den Leiterbahnen LS1 und LS2 wird zwischen den Leiterbahnen LE1 und LE2 wirksam. Außerdem durchsetzt ein Teil des vom Strom in der Sendeschleife LS1-LS2 erzeugten Flusses $\phi$ (des magnetischen Feldes) die Empfängerschleife LE1-LE2 und erzeugt dort eine entsprechende elektromotorische Kraft EMK.

Die Figur 2 verdeutlicht die Anordnung der Leiterbahnen zwischen den steckerseitigen Anschlußpunkten ANA und den zur Verkabelung abgehenden Anschlußpunkten ABA. Daraus ist erkennbar, daß die einzelnen Leiterbahnen parallel geführt sind, so daß über den gesamten Verlauf auf der Leiterplatine LP die in Figur 1 gezeigten Verhältnisse zutreffen. Aufgrund der bestehenden und festgelegten Belegung liegt die Empfängerschleife LE1-LE2 (Belegung 4-5) zwischen der Senderschleife LS1-LS2 (Belegung 3-6).

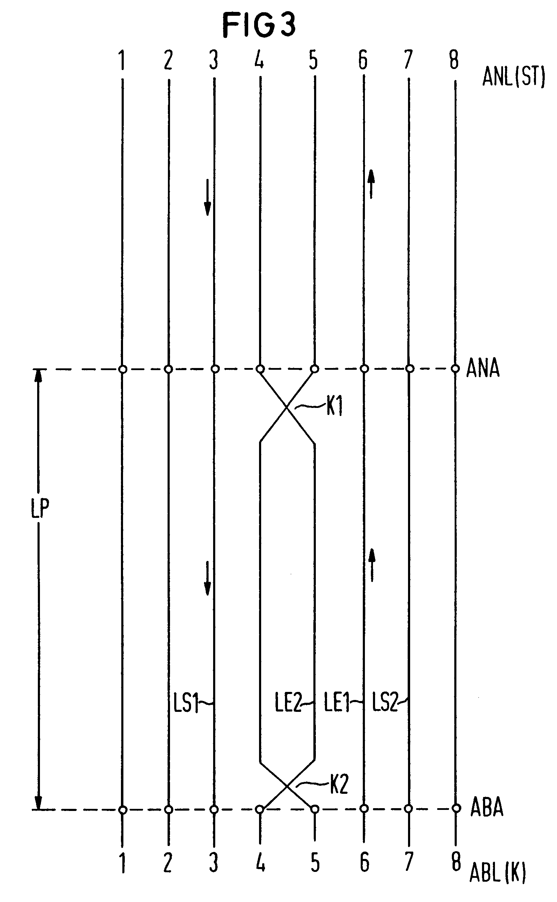

In Figur 3 wird eine Maßnahme zur Nebensprechkompensation gemäß der Erfindung erläutert, die auf der Leiterplatine LP durchgeführt wird. Hier wird die Kompensation des Nebensprechens durch sogenanntes "Auskreuzen" der Empfängerschleife LE1-LE2 vorgenommen. Da die Steckerbelegung aufgrund der bestehenden Systeme und damit die ankommenden Leitungen ANL des Steckers ST sowie die Belegung der abgehenden Leitungen ABL zur Verkabelung K beibehalten werden müssen, ist notwendig, daß das "Auskreuzen" im Kreuzungspunkt K1 in einem zweiten Kreuzungspunkt K2 rückgängig gemacht werden muß. Damit ist die Forderung bezüglich der beizubehaltenden Belegung erfüllt, wobei die Störung durch die erfindungsgemäße Nebensprechkompensation durch "Auskreuzung" weitestgehend verringert ist.

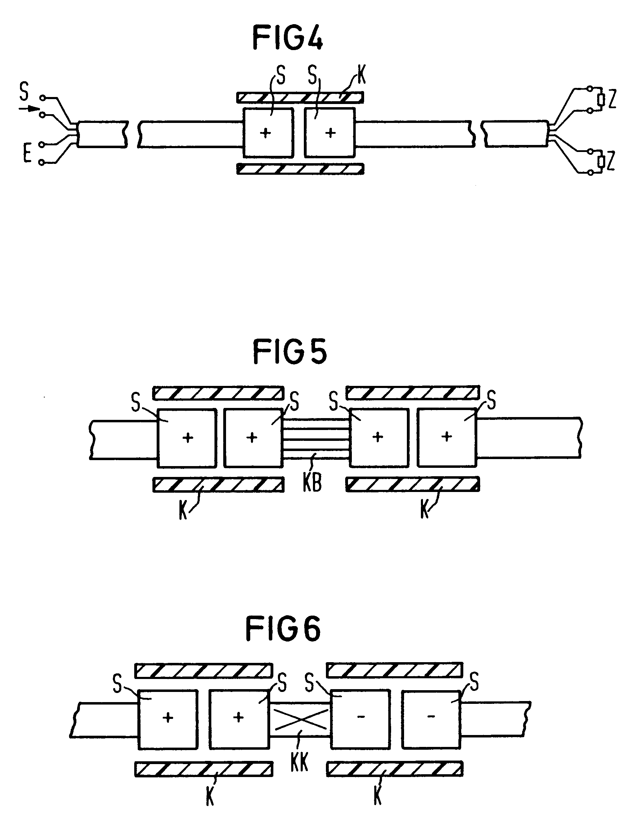

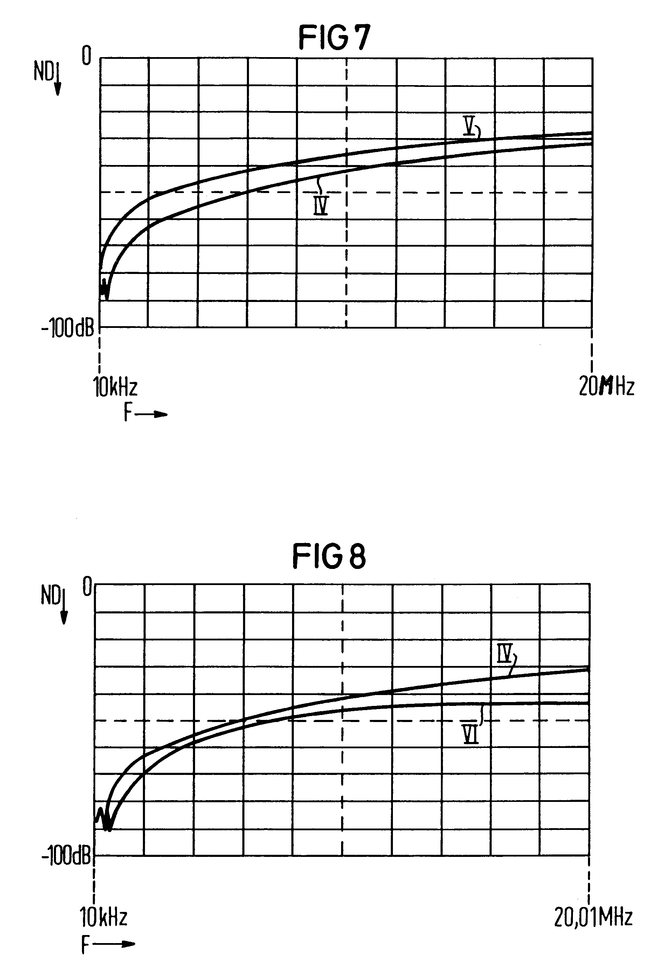

Die Wirksamkeit des "Kreuzens" wird nun anhand von Versuchen nach den Figuren 4 bis 6 und den Meßergebnissen nach den Figuren 7 und 8 nachgewiesen.

Die Figur 4 zeigt die Zusammenführung von zwei kurzen Kabeln, die an ihren Enden mit jeweils einem Stecker S (zum Beispiel RJ 45 - Stecker) versehen sind, in einer entsprechenden Kupplung K (RJ 45-Kupplung). Dabei wurde das Nahnebensprechen gemessen, das in den Kurven IV der Figuren 7 und 8 als Referenzmeßkurve aufgezeigt ist. So ergibt sich mit dieser Meßanordnung bei der Frequenz von 18 MHz eine Nebensprechdämpfung von 34,3 dB. Nun wurde eine Meßanordnung nach Figur 5 gewählt, bei der ein sehr kurzes Kabelstück KB mit zwei weiteren Steckern S (RJ 45-Stecker) in Kupplungen K mit bisher üblicher Kontaktbelegung in die Meßanordnung eingefügt. Die erstellte Meßkurve V ist in Figur 7 wiedergegeben und zeigt, daß die Nahnebensprechdämpfung auf 29,6 dB bei der Frequenz 18 MHz gesunken ist. Dies bedeutet, daß mit erhöhter Überkopplung gerechnet werden muß. Bei einer weiteren Meßanordnung nach Figur 6 wurde das vorher eingesetzte kleine Kabelstückchen KB durch ein ähnliches ersetzt, wobei an einem Steckeranschluß die Leiter an den Kontakten 4 und 5, das heißt die Anschlüsse der Empfängerschleife, vertauscht wurden. Die ermittelte Meßkurve VI ist in Figur 8 eingetragen und zeigt im Vergleich zur Referenzkurve IV, daß die Nebensprechdämpfung bei der Frequenz 18 MHz auf 44,2 dB gestiegen ist. Aus diesen Meßergebnissen ist zu schließen, daß eine Steckverbindung selbst bei der Frequenz 18 MHz ca. 37 dB Nebensprechdämpfung hat, die durch "Auskreuzen" wesentlich verbessert werden kann. Die Gegenkopplung braucht nun nicht durch einen weiteren Stecker wie bei der Meßanordnung erzeugt werden, sondern kann, wie es die Erfindung zeigt, durch verschiedene Leiteranordnungen bezüglich der Führung auf einer Leiterplatine erreicht werden.

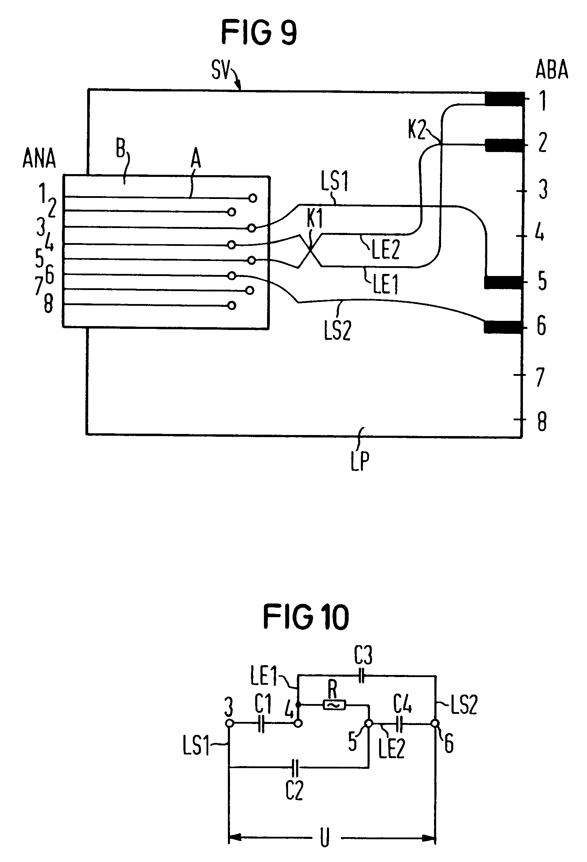

Eine solche Nebensprechkompensation gemäß der Erfindung wird nun in Figur 9 angedeutet, wobei hier die Nebensprechkompensation durch "Auskreuzen" im Kreuzungspunkt K1 der Empfängerleitbahnen LE1 und LE2 erfolgt. Zur Beibehaltung der Belegung an den abgehenden Anschlüssen ABA wird eine "Rückkreuzung" im Kreuzungspunkt K2 vorgenommen. Die Leiterbahnen der Sendeschleife LS1 und LS2 sind ohne Kreuzung geführt, wobei der Verlauf der einzelnen Bahnen zusätzlich so gewählt werden kann, daß auch dadurch die Überkopplung bereits auf ein Minimum reduziert wird. Die Darstellungsweise in der Figur 9 ist nur schematisch anzusehen, der tatsächliche Verlauf der Leiterbahnen erfolgt zum Beispiel in verschiedenen Ebenen der Leiterplatine LP. Bei einer solchen Anordnung ist also zusätzlich gewährleistet, daß die bereits festgelegten Belegungen ANA in der Buchse B mit den Anschlußfahnen A sowie die Belegungen ABA 1 bis 8 zur Verkabelung erhalten bleiben.

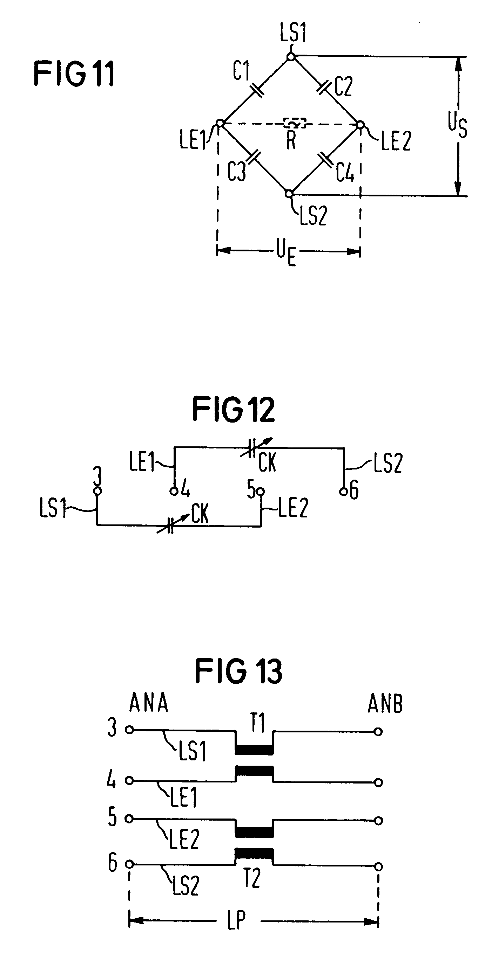

Eine Kompensation gemäß der Erfindung kann auch durch Einbau von Kondensatoren erzielt werden. Die Figur 10 zeigt die Kopplungen durch das elektrische Feld in einem Ersatzschaltbild, wobei sich daraus eine Brückenschaltung ableiten läßt, wie sie die Figur 11 in umgezeichneter Weise darstellt. Dabei läßt sich die Verkopplung als Spannungsverhältnis in der Empfängerschleife und Senderschleife darstellen. So gilt hier die nachstehende mathematische Beziehung:

$$\frac{UE}{US} = \frac{j\,\omega\,(C2{\cdot}C3\;-\;C1{\cdot}C4){\cdot}R}{j\,\omega\,(C1\;+\;C3)\,(C2\;+\;C4).R\;+\;C1\;+\;C2\;+\;C3\;+\;C4}$$

Die Verkopplung kann nun, wie aus der mathematischen Formel abzuleiten ist, dadurch minimiert werden, wenn die Koppelgröße (C2 x C3 - C1 x C4) gegen null gebracht wird, was durch Einbau von Kondensatoren realisiert werden kann. Die Größenverhältnisse dieser Kondensatoren liegen im Bereich von 1 bis 10 pF.

Die Figur 12 zeigt eine solche Nebensprechkompensation gemäß der Erfindung mit Hilfe von kompensierenden Kondensatoren CK, die zwischen den Anschlußpunkten LE1 (Anschluß 4) und LS2 (Anschluß 6) bzw. zwischen LS1 (Anschluß 3) und LE2 (Anschluß 5) angebracht werden müssen. Vorzugsweise sind diese Kondensatoren regelbar, so daß jeweils optimale Verhältnisse eingeregelt werden können.

In ähnlicher Weise können auch magnetische Kopplungen durch Gegeninduktivitäten gemäß der Erfindung kompensiert werden, wie in Figur 13 angedeutet ist. Dort werden zwischen den Anschlußpunkten ANA und ANB jeweils kleine Spulen in Form von Transformatoren T1 bzw. T2 so eingeschaltet, daß sie als Gegeninduktivitäten wirken und dadurch eine Kompensation ergeben. Hierzu müssen die zur Kompensation gekoppelten Leitungen (LS1 und LE1 sowie LE2 und LS2) an den Spulen T1 und T2 so angeschlossen werden, daß die jeweilige Kopplung verringert bzw. aufgehoben wird.

Diese beschriebenen Maßnahmen auf den Leiterplatinen können auch an den Geräteeingängen und Geräteausgängen und an den Steckbuchsen eingesetzt werden, zum Beispiel bei dem SML-System (Siemens-Modular-Link) in Verteilerschränken und Geräteanschlußdosen. Außerdem können auf diese Weise auch kompensierte Kupplungen für Stecker hergestellt werden, mit denen jeweils zwei mit Steckern (zum Beispiel RJ 45-Stecker) versehene Kabel verbunden werden können. Durch derartige Maßnahmen kann die Nebensprechdämpfung des gesamten Systems wesentlich erhöht werden, so daß größere Reichweiten erzielt werden können.

## Patentansprüche

1. Steckverbindung für Computernetze im Hausbereich, bestehend aus einem Stecker- und einem Buchsenteil,
   **dadurch gekennzeichnet,**
   daß eine Einrichtung zur Nebensprechkompensation (K1, K2, CK, T1, T2) in der Steckverbindung (SV) angeordnet ist, mit der die Nebensprechdämpfung zwischen der Sende- (LS1, LS2) und der Empfangs- (LE1, LE2) -Leiterschleife erhöhbar ist.

2. Steckverbindung nach Anspruch 1,
   **dadurch gekennzeichnet,**
   daß eine Leiterplatine (LP) in dem Buchsenteil oder dem Steckerteil der Steckverbindung (SV) zwischen den Anschlüssen (ANA) des Steckkabels und den Anschlüssen (ABA) zur Verkabelung angeordnet ist, daß die Leiterführungen der Sende- (LS1, LS2) und Empfangs- (LE1, LE2) -Leiterschleifen auf der Leiterplatine (LP) räumlich weitgehend getrennt sind.

3. Steckverbindung nach Anspruch 1,
   **dadurch gekennzeichnet,**
   daß in einer Leiterführung der Empfangs-Schleife (LE1, LE2) auf einer Leiterplatine (LP) eine doppelte Kreuzung vorgenommen ist.

4. Steckverbindung nach Anspruch 1,
   **dadurch gekennzeichnet,**
   daß die Einrichtung zur Nebensprechkompensation durch Anordnung diskreter Bauteile (CK, T1, T2) zwischen den Leiterschleifen (LS, LE) gebildet ist.

5. Steckverbindung nach Anspruch 4,
**dadurch gekennzeichnet**,
daß Kondensatoren (CK), vorzugsweise veränderbare, angeordnet sind.

6. Steckverbindung nach Anspruch 4,
**dadurch gekennzeichnet**,
daß Spulen (T1, T2) angeordnet sind.

7. Steckverbindung nach einem der vorhergehenden Ansprüche,
**dadurch gekennzeichnet**,
daß die Einrichtungen zur Nebensprechkompensation auf Leiterplatinen (LP) an den Ein- und Ausgängen der Geräte, insbesondere von Computern, angeordnet sind.

8. Steckverbindung nach einem der Ansprüche 1 bis 6,
**dadurch gekennzeichnet**,
daß die Einrichtungen zur Nebensprechkompensation in Kupplungseinheiten mit Buchsen- und Steckerteilen angeordnet sind.

9. Verfahren zur Erhöhung der Nebensprechdämpfung in Steckverbindungen nach einem der vorhergehenden Ansprüche,
**dadurch gekennzeichnet**,
daß auf einer/der Leiterplatine (LP) zwischen Eingangs- (ANA) und Ausgangs- (ABA) -Anschlüssen Maßnahmen zur Entkopplung der Sende- (LS1, LS2) und Empfangs- (LE1, LE2) -Leiterschleifen getroffen werden.

10. Verfahren nach Anspruch 9,
**dadurch gekennzeichnet**,
daß eine Nebensprechkompensation durch doppeltes Auskreuzen (K1, K2) der Empfangs-Leiterschleifen (LE1, LE2) auf der Leiterplatine (LP) durchgeführt wird.

11. Verfahren nach Anspruch 9,
**dadurch gekennzeichnet**,
daß eine Nebensprechkompensation durch Anordnen und Ausgleich mittels Kondensatoren (CK) zwischen den Sende- ((LS1, LS2) und Empfangs- (LE1, LE2) -Leiterschleifen durchgeführt wird.

12. Verfahren nach Anspruch 9,
**dadurch gekennzeichnet**,
daß eine Nebensprechkompensation durch Anordnung von gegeneinander wirkenden, abgestimmten Transformatorspulen (T1, T2) durchgeführt wird.


**Claims**

1. Plug connection for local area computer networks, comprising a plug and a socket part, characterized in that a device for crosstalk compensation (K1, K2, CK, T1, T2) is arranged in the plug connection (SV), by means of which the crosstalk attenuation between the transmitting (LS1, LS2) and the receiving (LE1, LE2) conductor loop can be increased.

2. Plug connection according to Claim 1, characterized in that a printed circuit board (LP) is arranged in the socket part or the plug part of the plug connection (SV) between the connections (ANA) of the plug cable and the connections (ABA) for cabling, and in that the conductor guides of the transmitting (LS1, LS2) and receiving (LE1, LE2) conductor loops on the printed circuit board (LP) are spatially separated to a large extent.

3. Plug connection according to Claim 1, characterized in that double transposition is implemented in one conductor guide of the receiving loop (LE1, LE2) on a printed circuit board (LP).

4. Plug connection according to Claim 1, characterized in that the device for crosstalk compensation is formed by arranging discrete components (CK, T1, T2) between the conductor loops (LS, LE).

5. Plug connection according to Claim 4, characterized in that capacitors (CK), preferably variable capacitors, are arranged.

6. Plug connection according to Claim 4, characterized in that coils (T1, T2) are arranged.

7. Plug connection according to one of the preceding claims, characterized in that the devices for crosstalk compensation are arranged on printed circuit boards (LP) at the inputs and outputs of the equipment, in particular computers.

8. Plug connection according to one of Claims 1 to 6, characterized in that the devices for crosstalk compensation are arranged in coupling units with socket and plug parts.

9. Method for increasing the crosstalk attenuation in plug connections according to one of the preceding claims, characterized in that measures are taken on a printed circuit board (LP) between the input (ANA) and output (ABA) connections to decouple the transmitting (LS1, LS2) and receiving (LE1, LE2) conductor loops.

10. Method according to Claim 9, characterized in that crosstalk compensation is carried out by double transposition (K1, K2) of the receiving conductor loops (LE1, LE2) on the printed circuit board (LP).

11. Method according to Claim 9, characterized in that crosstalk compensation is carried out by arranging capacitors (CK), and using them for compensation, between the transmitting (LS1, LS2) and receiving (LE1, LE2) conductor loops.

12. Method according to Claim 9, characterized in that crosstalk compensation is carried out by arranging mutually acting, tuned transformer coils (T1, T2).

## Revendications

1. Connecteur pour réseaux d'ordinateurs dans le domaine ménager, constitué par une partie en forme de fiche et une partie en forme de douille,
   caractérisé par le fait qu'un dispositif pour compenser la diaphonie (K1,K2,CK,T1,T2) est disposé dans le connecteur (SV) , ce dispositif permettant d'écouter l'affaiblissement de la diaphonie entre la boucle des conducteurs d'émission (LS1,LS2) et la boucle des conducteurs de réception (LE1,LE2).

2. Connecteur suivant la revendication 1, caractérisé par le fait qu'une platine (LP) portant des conducteurs est disposée dans la partie en forme de douille ou dans la partie en forme de fiche du connecteur (SV) entre les bornes (ANA) du cadre d'enfichage et les bornes (ABA) utilisées pour le câblage, en sorte que les trajets des boucles conductrices d'émission (LS1,LS2) des boucles conductrices de réception (LE1,LE2) sur la platine à circuits imprimés (LP) sont largement séparés dans l'espace.

3. Connecteur suivant la revendication 1, caractérisé par le fait qu'un double croisement est réalisé dans un trajet conducteur de la boucle de réception (LE1,LE2) sur une platine à circuits imprimés (LP).

4. Connecteur suivant la revendication 1, caractérisé par le fait que le dispositif de compensation de la diaphonie est formé par le montage de composants discrets (CK,T1,T2) entre les boucles de conducteurs (LS,LE).

5. Connecteur suivant la revendication 4, caractérisé par le fait qu'il est prévu des condensateurs (CK), de préférence réglables.

6. Connecteur suivant la revendication 4, caractérisé par le fait que des bobines (T1,T2) sont prévues.

7. Connecteur suivant l'une des revendications précédentes, caractérisé par le fait que les dispositifs de compensation de la diaphonie sont disposés sur des platines à circuits imprimés (LK), au niveau des entrées et des sorties des appareils, notamment d'ordinateurs.

8. Connecteur suivant l'une des revendications 1 à 6, caractérisé par le fait que les dispositifs de compensation de la diaphonie sont disposés dans des unités d'accouplement comportant des parties en forme de douilles et des parties en forme de fiches.

9. Procédé pour accroître l'affaiblissement de la diaphonie dans des connecteurs suivant l'une des revendications précédentes, caractérisé par le fait que des dispositions pour découpler les boucles conductrices d'émission (LS1,LS2) et les boucles conductrices de réception (LE1, LE2) sont prévus sur une/la platine à circuits imprimés (LP) entre la borne d'entrée (ANA) et la borne de sortie (ABA).

10. Procédé suivant la revendication 9, caractérisé par le fait qu'une compensation de la diaphonie est réalisée au moyen d'un double croisement (K1,K2) des boucles conductrices de réception (LE1,LE2) sur la platine à circuits imprimés (LP).

11. Procédé suivant la revendication 9, caractérisé par le fait qu'une compensation de la diaphonie est réalisée grâce à un montage et à une compensation à l'aide de condensateurs (CK) entre les boucles conductrices d'émission (LS1,LS2) et les boucles conductrices de réception (LE1,LE2).

12. Procédé suivant la revendication 9, caractérisé par le fait qu'une compensation de la diaphonie est réalisée par un dispositif formé de bobines accordées de transformateurs (T1,T2), qui agissent en des sens opposés.

# FIG 1

# FIG 2

# FIG 3

## FIG4

## FIG 5

## FIG 6

# FIG 7

# FIG 8

## FIG 9

## FIG 10

**FIG 11**

**FIG 12**

**FIG 13**